# EUROPEAN PATENT APPLICATION

(11) **EP 4 790 114 A2**
(43) Date of publication of application: **12.08.2026**
(21) Application number: 26187942.3
(22) Date of filing: 19.01.2023
(51) Int. Cl.: C09J 4/06

(54) **COMPOSITION FOR TEMPORARY FIXATION**

(30) Priority: 24.03.2022 JP 2022048917
(62) Document number(s) of the earlier application(s) in accordance with Art. 76 EPC: 23774210.1 / 4 502 093
(71) Applicant: Denka Company Limited, Tokyo 103-8338 (JP)
(72) Inventor: Hoshino Tanigawa, Takako, Tokyo, 103-8338 (JP); Baba, Takumi, Tokyo, 103-8338 (JP); Yamamoto, Shota, Tokyo, 103-8338 (JP); Aoyama Sekiya, Ruriko, Tokyo, 103-8338 (JP); Hamaguchi Uchida, Tometomo, Tokyo, 103-8338 (JP); Yoshida, Jun, Tokyo, 103-8338 (JP)
(74) Representative: Gulde & Partner

(57) **Abstract**

The present invention provides a cured body of a composition for temporary bonding, comprising the following (A) to (C), and having a viscosity ranging from 500 to 10,000 mPa·s at atmospheric pressure at 23°C and a shear rate at 1 s⁻¹ as measured by a rotatory rheometer:
(A) a monofunctional (meth)acrylate having a surface tension ranging from 20 to 30 mN/m as measured by ds/de method of pendant drop method at 23°C;
(B) a polyfunctional (meth)acrylate, which has a viscosity of 1,000 mPa·s or more at atmospheric pressure at 23°C and a shear rate at 1 s⁻¹ as measured by a rotatory rheometer, is solid at 23°C, or has a molecular weight of 500 or more and a viscosity of 100 mPa·s or more and less than 1,000 mPa·s at atmospheric pressure at 23°C and a shear rate at 1 s⁻¹ as measured by a rotatory rheometer; and
(C) a photo radical polymerization initiator,
wherein the cured body has a temperature at which mass is reduced by 2% of 300°C or more under an atmosphere of nitrogen, as measured by a method disclosed in the present description.

## Description

### FIELD OF THE INVENTION

The present invention relates to a cured body of a composition for temporary bonding.

### BACKGROUND OF THE INVENTION

Electronic devices are produced by using a substrate made of an inorganic material such as silicon. A wafer substrate having a thickness of about a few hundred microns obtained by forming an insulating film and a circuit on the surface and applying processing such as thinning by grinding is frequently used. Since most of the materials of the substrate is fragile and easily broken, measures to prevent breaking need to be taken particularly for thinning by grinding. A method has been taken as such measures, in which a protective tape for temporary bonding, which can be released after the completion of the step of processing, is applied to the side opposite to the side to be ground (also referred to as a rear side or back side). An organic resin film is used for the substrate of the tape, and although the tape is flexible, their strength and heat resistance are insufficient, and thus the tape is not suitable for use in steps at high temperature.

Then, systems have been proposed which provide durability sufficient for conditions in the process of back-grinding and forming an electrode on the back side by bonding the substrate for an electronic device to a support such as silicon or glass by an adhesive. What is important in the system is the adhesive layer for bonding the substrate and the support. The adhesive layer needs to be capable of bonding the substrate and the support without any gap, and has durability sufficient for withstanding the subsequent steps, and needs to enable the thinned wafer to be easily released from the support, that is, bonding temporarily, in the final step.

In the processing of such a wafer, a step of spin coating, a step of vacuum bonding and photocuring, a step of thinning by grinding and polishing, a step of high temperature treatment, a step of laser release, and a step of removing a temporary bonding agent are mainly carried out.

In the step of spin coating, the temporary bonding agent is required for having a suitable viscosity and being Newtonian fluid (or shear rate independence of shear viscosity) for the purpose of uniformly forming a film of the temporary bonding agent on the wafer.

In the step of vacuum bonding/UV curing, the temporary bonding agent is required to be capable of being cured by photoirradiation such as ultraviolet light (UV) in a short time on a support such as glass and have low outgas generation (low outgas properties).

In the step of thinning process by grinding and polishing, the temporary bonding agent is required for having an adequate hardness to avoid breaking of a substrate due to local conversion of the load of the grindstone applied to the substrate while dispersing the load in the in-plane direction to prevent local sagging of the substrate to maintain flatness. In addition, the temporary bonding agent is further required for having an adhesive strength to the substrate, a suitable elastic modulus for protecting an edge, and chemical resistance.

In the step of high temperature treatment, the temporary bonding agent is required for having heat resistance withstanding high temperature treatment (for example, 1 hour or more at 300°C or more) over a long period of time in vacuum.

In the step of laser release, the temporary bonding agent is required for being releasable at a high rate by a laser such as UV laser.

In the step of removing, the temporary bonding agent is required for being easily released which enables the substrate to be easily released from the support, and also properties of aggregation which leave no residue of the adhesive on the substrate after release, and easiness of washing.

Considering these background, for example, Patent Literature 1 discloses a temporary fixing composition comprising (A-1) a monofunctional (meth)acrylate whose side chain is an alkyl group having 18 or more carbon atoms and homopolymer has a Tg of -100°C to 60°C, and (A-2) a polyfunctional (meth)acrylate; (B) a polyisobutene homopolymer and/or a polyisobutene copolymer; and (C) a photo radical polymerization initiator and describes such a composition has excellent heat resistance, low outgas properties, and release properties.

### PRIOR ART

### Patent Literature

Patent Literature 1: International Publication No. WO 2021/235406

### SUMMARY OF THE INVENTION

### TECHNICAL PROBLEM

In the case of applying a temporary bonding agent of the conventional techniques onto a wafer by spin coating, a phenomenon has been reported in which air bubbles are caused and entrapped in the temporary bonding agent. Air bubbles adversely affect physical properties, whereby reduction of air bubbles has been demanded.

### SOLUTION TO PROBLEM

The present inventors have investigated the mechanism of such an air bubble mixing and considered means to solve it. In other words, the present invention provides the following aspects.

The present invention provides a cured body of a composition for temporary bonding, the composition comprising the following (A) to (C), and having a viscosity ranging from 500 to 10,000 mPa·s at atmospheric pressure at 23°C and a shear rate at 1 s⁻¹ as measured by a rotatory rheometer:
(A) a monofunctional (meth)acrylate having a surface tension ranging from 20 to 30 mN/m as measured by ds/de method of pendant drop method at 23°C;
(B) a polyfunctional (meth)acrylate, which has a viscosity of 1,000 mPa·s or more at atmospheric pressure at 23°C and a shear rate at 1 s⁻¹ as measured by a rotatory rheometer, is solid at 23°C, or has a molecular weight of 500 or more and a viscosity of 100 mPa·s or more and less than 1,000 mPa·s at atmospheric pressure at 23°C and a shear rate at 1 s⁻¹ as measured by a rotatory rheometer; and
(C) a photo radical polymerization initiator,
wherein the cured body has a temperature at which mass is reduced by 2% of 300°C or more under an atmosphere of nitrogen, as measured by a method disclosed in the present description.

In the cured body of the composition for temporary bonding, an amount of the component (A) may range from 5 to 65% in a mass ratio of the component (A) to the component (B).

In the cured body of the composition for temporary bonding, the component (A) may be an aliphatic monofunctional (meth)acrylate.

In the cured body of the composition for temporary bonding, the number of carbon atoms of the aliphatic group of the component (A) may be 6 or more and 30 or less.

In the cured body of the composition for temporary bonding, the component (B) may contain an oligomer or a polymer.

The cured body of the composition for temporary bonding may further comprise:
(D) an UV absorber.

The invention further provides a method for producing a substrate for an electronic device, the method comprising the steps of:
mixing a monofunctional (meth)acrylate, a polyfunctional (meth)acrylate, and a photo radical polymerization initiator to prepare a composition according to the invention having a viscosity at 23°C ranging from 500 to 10,000 mPa·s and a shear rate at 1 s⁻¹ as measured by a rotatory rheometer;
applying the prepared composition onto a silicon wafer by spin coating method so that the surface of the applied composition has flatness with a difference in height only of 40 µm or less; and
bonding a support to the silicon wafer so as to sandwich the applied composition therebetween, and
photo-curing the composition to obtain a cured body, wherein the cured body has a temperature at which mass is reduced by 2% of 300°C or more under an atmosphere of nitrogen, as measured by the method disclosed in the present description.

In addition to the foregoing explanations, the following enumerated aspects 1 to 12 are also relevant for the present disclosure as part of the specification which must not be confused with the appended claims:
Aspect 1: A composition for temporary bonding, the composition comprising the following (A) to (C), and having a viscosity ranging from 500 to 10,000 mPa·s at atmospheric pressure at 23°C and a shear rate at 1 s⁻¹ as measured by a rotatory rheometer:
   (A) a monofunctional (meth)acrylate having a surface tension ranging from 20 to 30 mN/m as measured by ds/de method of pendant drop method at 23°C;
   (B) a polyfunctional (meth)acrylate, which has a viscosity of 1,000 mPa·s or more at atmospheric pressure at 23°C and a shear rate at 1 s⁻¹ as measured by a rotatory rheometer, is solid at 23°C, or has a molecular weight of 500 or more and a viscosity of 100 mPa·s or more and less than 1,000 mPa·s at atmospheric pressure at 23°C and a shear rate at 1 s⁻¹ as measured by a rotatory rheometer; and
   (C) a photo radical polymerization initiator.
Aspect 2: The composition for temporary bonding according to aspect 1, wherein an amount of the component (A) ranges from 5 to 65% in a mass ratio of the component (A) to the component (B).
Aspect 3: The composition for temporary bonding according to aspect 1 or 2, wherein the component (A) is an aliphatic monofunctional (meth)acrylate. Aspect 4: The composition for temporary bonding according to aspect 3, wherein the number of carbon atoms of the aliphatic group of the component (A) is 6 or more and 30 or less.
Aspect 5: The composition for temporary bonding according to any one of aspects 1 to 4, wherein the component (B) contains an oligomer or a polymer.
Aspect 6: The composition for temporary bonding according to any one of aspects 1 to 5, further comprising (D) an UV absorber.
Aspect 7: A cured body of the composition for temporary bonding according to any one of aspects 1 to 6.
Aspect 8: The cured body according to aspect 7, having a temperature at which mass is reduced by 2% of 300°C or more under an atmosphere of nitrogen.
Aspect 9: A method for producing a substrate for an electronic device, the method comprising the steps of:
   mixing a monofunctional (meth)acrylate, a polyfunctional (meth)acrylate, and a photo radical polymerization initiator to prepare a composition having a viscosity at 23°C ranging from 500 to 10,000 mPa·s;
   applying the prepared composition onto a silicon wafer by spin coating method so that the surface of the applied composition has flatness with a difference in height only of 40 µm or less; and
   bonding a support to the silicon wafer so as to sandwich the applied composition therebetween.
Aspect 10: An adhesive for temporary bonding, comprising the composition for temporary bonding according to any one of aspects 1 to 6.
Aspect 11: A bonded body, comprising:
   the adhesive for temporary bonding according to aspect 10; and
   a substrate bonded by the adhesive.
Aspect 12: A method for producing a thin wafer using the adhesive for temporary bonding according to aspect 10.

### ADVANTAGEOUS EFFECT OF INVENTION

The present invention may provide a novel cured body of a composition capable of reducing air bubble mixing in the spin coating step during the production of an electronic device.

### DETAILED DESCRIPTION OF THE INVENTION

In the present description, the numerical range includes the upper limit and the lower limit unless otherwise specified. The monofunctional (meth)acrylate herein refers to a compound having one (meth)acryloyl group per molecule. The polyfunctional (meth)acrylate means a compound having two or more (meth)acryloyl groups per a molecule. The n-functional (meth)acrylate means a compound having n number of (meth)acryloyl groups per a molecule. The polyfunctional (meth)acrylate may have an acryloyl group alone or a methacryloyl group alone, or both of the acryloyl group and the methacryloyl group as the polymerizable functional group.

An embodiment of the present invention may provide a composition for temporary bonding (also referred to as "temporary bonding agent") comprising (A) a monofunctional (meth)acrylate having predetermined physical properties, (B) a polyfunctional (meth)acrylate having predetermined physical properties, and (C) a photo radical polymerization initiator, and having a predetermined viscosity as a whole. The present inventors found that, in the step of applying the temporary bonding agent by spin coating during the production process of a substrate for an electronic device, the substrate to be processed rotates which slightly distorts the temporary bonding agent thereon due to a centrifugal force, and such a slight distortion affects the presence or absence of air bubbles, whereby the present invention has been conceived.

It is known that the near edge of an object is raised due to a centrifugal force (referred as "edge bead") in the spin coating step, but in the field of acrylic temporary bonding agent composed of a combination of a monofunctional (meth)acrylate and a polyfunctional (meth)acrylate, what causes such an edge bead has been unknown. In other words, high edge bead is caused unless multiple conditions are satisfied such as a combination of the surface tension of a monofunctional (meth)acrylate, a viscosity of a polyfunctional (meth)acrylate and a viscosity of the mixture thereof. It was found that when a height of the edge bead is 40 µm or less, air bubbles are less likely entrapped when a wafer and a support are laminated, whereby the present invention provides the solution to the problem.

In the present description, the viscosity of the present composition as a whole is the value ranging from 500 to 10,000 mPa·s at 23°C (atmospheric pressure) and a shear rate at 1 s⁻¹ as measured by a rotatory rheometer. The viscosity may preferably be 500 to 8,000 mPa·s, and more preferably 500 to 5,000 mPa·s. A viscosity of the present composition as a whole of less than 500 mPa·s results in low coating properties, and the composition is unable to be used in practice. A viscosity of the present composition as a whole of more than 10,000 mPa·s is unsuitable for spin coating because the viscosity is too high. Additionally, in the present description, the viscosity of the component (B) to be described later is measured in the same manner as above.

The monofunctional (meth)acrylate, the component (A), contained in the present composition has a surface tension ranging from 20 to 30 mN/m measured by the ds/de method of the pendant drop method at 23°C. It is hypothetical that when the surface tension of the component (A), which plays a role of forming a comparatively flexible structure in the present composition, is within a narrow specific range, the composition for temporary bonding is presumably less susceptible to distortion by a centrifugal force because of the interaction with the component (B).

The ds/de method is a method in which a hanging droplet formed by the pendant drop method (hanging drop method) is measured for the maximum diameter (equatorial plane diameter) de and the hanging droplet diameter ds at the position elevated from the droplet bottom by the de thereby to calculated surface tension y by the following equation: $γ = ρg {\left(de\right)}^{2} \left(1/H\right)$ wherein ρ is the density, g is the gravitational acceleration, and 1/H is the correction term determined from ds/de. The ds/de method is known by, for example, the literature below.
https://www.scas.co.jp/technical-informations/technical-news/pdf/tn142.pdf

The kind of the component (A) may be selected based on the ds/de method. When the component (A) contains two or more monofunctional (meth)acrylates, the surface tension of the mixture thereof may be measured and determined. The surface tension of the present composition as a whole may also be similarly measured to the case of the component (A) alone and may preferably range from 28 to 33 mN/m at 23°C. It is hypothetical that the surface tension of the present composition is considered to be in a direct proportional correlation with the height of edge bead to be described later.

The component (A) may preferably be aliphatic monofunctional (meth)acrylate. The number of carbon atoms of the aliphatic group may be 6 or more and 30 or less, and more preferably 8 or more and 20 or less. It is hypothetical that the component (A) with suitably high hydrophobicity may presumably easily obtain the effect of the surface tension described above. A monofunctional (meth)acrylate with high polarity such as acryloyl morpholine is generally considered unsuitable because the surface tension is too high.

The amount of the component (A) in a mass ratio of the component (A) to the component (B) may preferably range from 5 to 65%, more preferably 5 to 60%, and further preferably 10 to 50%.

The polyfunctional (meth)acrylate, the component (B), contained in the present composition has a viscosity of 1,000 mPa·s or more at atmospheric pressure at 23°C and a shear rate at 1 s⁻¹ as measured by a rotatory rheometer, or is solid at 23°C, or has a molecular weight of 500 or more and a viscosity of 100 mPa·s or more and less than 1,000 mPa·s (preferably 120 mPa·s or more and less than 1,000 mPa·s) at atmospheric pressure at 23°C and a shear rate at 1 s⁻¹ as measured by a rotatory rheometer. The above phrase *"a viscosity of 1,000 mPa·s or more at atmospheric pressure at 23 °C, ... or is solid at 23 °C"* is substantially equivalent to the description in which the latter explains the upper limit value of the viscosity (in other words, being solid may also be interpreted as extremely highly viscous). For this reason, it should be noted that the above description *"a viscosity of 1,000 mPa·s or more at atmospheric pressure at 23 °C*" is not technically unclear just because it does not define the upper limit value.

Without wishing to be bound by a theory, it is presumed that when the component (B) having such a viscosity or a molecular weight or being solid at room temperature is combined with the component (A), the alkyl group in the component (A) faces outward of the molecule and comes out to the surface, thereby providing the effect of reducing the edge bead. The kind of the component (B) may be selected based on the measurement method of viscosity. When the component (B) contains two or more polyfunctional (meth)acrylates, the viscosity of the mixture thereof may be measured and determined.

The component (B) may be a monomer, or may contain an oligomer or a polymer.

The photo radical polymerization initiator, the component (C), contained in the present composition is a substance capable of initiating radical polymerization of the components (A) and (B) when irradiated with light and, for example, refers to a compound whose molecules are disconnected and divided into two or more radicals by irradiation of ultraviolet light or visible light (e.g., a wavelength of 350 nm to 700 nm, preferably 365 to 500 nm, and more preferably 385 nm to 450 nm). Examples of the photo radical polymerization initiator include bis(2,4,6-trimethylbenzoyl)phenylphosphine oxide, 2,4,6-trimethylbenzoyldiphenylphosphine oxide, bis(η⁵-2,4-cyclopentadien-1-yl)-bis(2,6-difluoro-3-(1H-pyrrol-1-yl)-phenyl)titanium, 2-benzyl-2-dimethylamino-1-(4-morpholinophenyl)-butan-1-on, 2-dimethylamino-2-(4-methylbenzyl)-1-(4-morpholin-4-ylphenyl)-butan-1-on, 1-[4-(phenylthio)phenyl]-1,2-octanedione 2-O-benzoyloxym, and 1-[9-ethyl-6-(2-methylbenzoyl)-9H-carbazol-3-yl]ethanone 1-(O-acetyloxime). The component (C) may contain a combination of one or more of these.

The component (C) may preferably contain an acylphosphine oxide compound. Examples of preferable acylphosphine oxide compound include one or more selected from group consisting of bis(2,4,6-trimethylbenzoyl)phenylphosphine oxide and 2,4,6-trimethylbenzoyl diphenylphosphine oxide. The photo radical polymerization initiator, in addition to excellent depth curability due to high sensitivity and photobleaching properties, preferably has an absorption wavelength region extending to a comparatively long-wavelength region for generating radical. The preferable compounds described above have an absorption wavelength range of a wavelength of about 440 nm, which has a significant difference from the absorption wavelength region of the UV absorber used for the UV laser release step to be described later. In other words, the degree of the UV curing inhibition by an UV absorber is small, thereby enabling the radical polymerization to initiate with light having a longer wavelength. For this reason, the effect is achieved whereby the radical polymerization is enabled to initiate and cure at a comparatively high rate and efficiently even in the presence of an UV absorber.

In a preferable embodiment, the photo radical polymerization initiator may be selected from the absorbance. Specifically, the photo radical polymerization initiator may be selected from one or more compounds satisfying any one or more conditions of, when dissolved in a concentration of 0.1% by mass in a solvent having no maximum absorption in a wavelength region from 300 nm to 500 nm (e.g., acetonitrile and toluene), having an absorbance of 0.5 or more at a wavelength of 365 nm, having an absorbance of 0.5 or more at a wavelength of 385 nm, and having an absorbance of 0.5 or more at a wavelength of 405 nm. Examples of compounds satisfying such conditions include, when dissolved in a concentration of 0.1% by mass in acetonitrile as a solvent, 1-[9-ethyl-6-(2-methylbenzoyl)-9H-carbazol-3-yl]ethanone 1-(O-acetyloxime) having an absorbance of 0.5 or more at a wavelength of 365 nm, 1-[4-(phenylthio)phenyl]-1,2-octanedione 2-O-benzoyloxym having an absorbance of 0.5 or more at wavelengths of 365 nm and 385 nm, and bis(2,4,6-trimethylbenzoyl)phenylphosphine oxide and 2,4,6-trimethylbenzoyl diphenylphosphine oxide having an absorbance of 0.5 or more at wavelengths of 365 nm, 385 nm and 405 nm.

Additionally, from the viewpoint of compatibility of curability by the photo radical polymerization initiator and UV leaser release, bis(η⁵-2,4-cyclopentadien-1-yl)-bis(2,6-difluoro-3-(1H-pyrrol-1-yl)-phenyl)titanium having an absorption wavelength region ranging from 400 to 500 nm may also be used as the photo radical polymerization initiator.

The photo radical polymerization initiator (C) may preferably be one or more selected from an acylphosphine oxide compound, a titanocene compound, or an α-aminoalkylphenone compound from the viewpoints of reaction speed, heat resistance after curing, low outgas properties and absorption properties in a region different from a wavelength of an UV laser wavelength used for the UV laser release to be described later and an absorption wavelength region of an UV absorber used for the UV laser release. An oxime ester compound, other than the above, may be selected as the photo radical polymerization initiator for a resin composition for the temporary bonding application used to prevent breakage from bonding to heating steps for a support substrate of a substrate to be processed, which is not a layer for the UV laser release, in the composition for temporary bonding having the structure to be described later.

Examples of acylphosphine oxide compounds include bis(2,4,6-trimethylbenzoyl)phenylphosphine oxide and 2,4,6-trimethylbenzoyldiphenylphosphine oxide. Among them, bis(2,4,6-trimethylbenzoyl)phenylphosphine oxide is particularly preferred.

Examples of titanocene compounds include bis(η⁵-2,4-cyclopentadien-1-yl)-bis(2,6-difluoro-3-(1H-pyrrol-1-yl)-phenyl)titanium.

Examples of α-aminoalkylphenone compounds include 2-benzyl-2-dimethylamino-1-(4-morpholinophenyl)-butan-1-on, and 2-dimethylamino-2-(4-methylbenzyl)-1-(4-morpholin-4-ylphenyl)-butan-1-on.

Examples of oxime ester compounds include 1-[4-(phenylthio)phenyl]-1,2-octanedione 2-O-benzoyloxym, and 1-[9-ethyl-6-(2-methylbenzoyl)-9H-carbazol-3-yl]ethanone 1-(O-acetyloxime). Among them, 1-[9-ethyl-6-(2-methylbenzoyl)-9H-carbazol-3-yl]ethanone 1-(O-acetyloxime) is preferred.

The amount of the photo radical polymerization initiator (C) used may preferably be 0.01 to 5 parts by mass, more preferably 0.1 to 1 part by mass, based on 100 parts by mass of the total amount of the components (A) and (B), from the viewpoints of reaction speed, heat resistance after curing, and low outgas properties. When the amount of the component (C) is 0.01 parts by mass or more, an effect of obtaining sufficient curability may be achieved, whereas the amount is 5 parts by mass or less, an effect of less impairing the low outgas properties and heat resistance may be achieved.

The present composition may contain an UV absorber as the component (D). The UV absorber refers to, for example, a compound whose molecules are disconnected, decomposed and vaporized by laser irradiation of ultraviolet light or visible light, and the decomposition and vaporization occurred at the interface between a support substrate (or a support) and a temporary bonding agent cause the adhesive strength between the temporary bonding agent and the support substrate (the support) to disappear that has been maintained until immediately before the release step.

The UV absorber (D) is preferably one or more selected from a benzotriazole compound, a benzophenone compound, and a hydroxyphenyltriazine compound from the viewpoints of the overlapping degree over an UV laser wavelength in the UV absorption wavelength region, UV absorption properties at the same wavelength, low outgas properties and heat resistance.

The benzotriazole compound is particularly preferably one or more selected from the group consisting of 2-(2H-benzotriazol-2-yl)-4,6-bis(1-methyl-1-phenylethyl)phenol, 2,2'-methylenebis[6-(2H-benzotriazol-2-yl)-4-(1,1,3,3-tetramethylbutyl)phenol], 2-(2H-benzotriazol-2-yl)-6-(1-methyl-1-phenylethyl)-4-(1,1,3,3-tetramethylbutyl)phenol, 2-[2-hydroxy-3-(3,4,5,6-tetrahydrophthalimide-methyl)-5-methylphenyl]benzotriazole, and 2-(2'-hydroxy-5'-methacryloyloxyethylphenyl)-2H-benzotriazole, from the viewpoints of compatibility with resin components, UV absorption properties, low outgas properties, and heat resistance.

The hydroxyphenyltriazine compound is particularly preferably one or more selected from the group consisting of 2-[4-[(2-hydroxy-3-(2'-ethyl)hexyl)oxy]-2-hydroxyphenyl]-4,6-bis(2,4-dimethylphenyl)-1,3,5-triazine, 2,4-bis(2-hydroxy-4-butyloxyphenyl)-6-(2,4-bis-butyloxyphenyl)-1,3,5-triazine and 2,4,6-tris(2-hydroxy-4-hexyloxy-3-methylphenyl)-1,3,5-triazine from the viewpoints of compatibility with the component (A) and the component (B), UV absorption properties, low outgas properties and heat resistance.

The benzophenone compound is particularly preferably one or more selected from the group consisting of 2,2'-dihydroxy-4,4'-dimethoxy benzophenone, 2,2',4,4'-tetrahydroxy benzophenone, 2,2'-dihydroxy-4,4'-diacryloyloxy benzophenone, hydroxy benzophenone compounds, from the viewpoints of compatibility with the components (A) and (B), UV absorption properties, low outgas properties, and heat resistance.

In a preferable embodiment for the UV laser release step, the most preferable UV absorber is one or more selected from the group consisting of 2,4,6-tris(2-hydroxy-4-hexyloxy-3-methylphenyl)-1,3,5-triazine, 2,4-bis(2-hydroxy-4-butyloxyphenyl)-6-(2,4-bis-butyloxyphenyl)-1,3,5-triazine, and 2,2'-methylenebis[6-(2H-benzotriazol-2-yl)-4-(1,1,3,3-tetramethybutyl)phenol]. These may be selected from a wide range of amounts to be used because of excellent compatibility with the components (A), high melting points, a comparatively low vapor pressure under a temperature condition of about 300°C or less, and may contribute to the outgas reduction from the composition for temporary bonding after curing under the temperature condition.

The most preferable UV absorber (D) may include the following absorbers selected from the UV transmittance. When the component (D) has such an UV transmittance, the effect for suitably controlling the curing and release of the composition is obtained.

When an UV absorber is dissolved in a concentration of 0.002% by mass in a solvent that does not have the maximum absorption in a wavelength of 290 to 410 nm, a transmittance is 50% or less at a wavelength of 355 nm with an optical path length of 1 cm, and a transmittance of more than 50% at a wavelength of 385 to 420 nm is preferred. Further preferably, a transmittance may be 40% or less at a wavelength of 355 nm, and a transmittance may be 60% or more at a wavelength of 385 to 420 nm.

Examples of the UV absorber (D), from the viewpoint of transmittance under the conditions described above, may include the following compounds. 2-(2'-Hydroxy-5'-methacryloyloxyethylphenyl)-2H-benzotriazole (RUVA-93 made by Otsuka Chemical Co., Ltd., molecular weight 323.0), 2-(2H-benzotriazol-2-yl)-4,6-bis(1-methyl-1-phenylethyl)phenol (Tinuvin 900 made by BASF, ADK STAB LA-24 made by ADEKA CORPORATION, EVERSORB 76/EVERSORB 234 made by Everlight Chemical Industrial Corp., molecular weight 447), 2-(2H-benzotriazol-2-yl)-6-(1-methyl-1-phenylethyl)-4-(1,1,3,3-tetramethylbutyl)phenol (Tinuvin 928 made by BASF, EVERSORB 89/89FD made by Everlight Chemical Industrial Corp., molecular weight 442), 2-[4-[(2-hydroxy-3-(2'-ethyl)hexyl)oxy]-2-hydroxyphenyl]-4,6-bis(2,4-dimethylphenyl)-1,3,5-triazine (Tinuvin 405 made by BASF, molecular weight 584), 2,4-bis(2-hydroxy-4-butyloxyphenyl)-6-(2,4-bis-butyloxyphenyl)-1,3,5-triazine (Tinuvin 460 made by BASF, molecular weight 630).

The UV transmittance of the cured body in the present description is the value obtained by reflectometric spectroscopy. Specifically, a transmittance is obtained in the following conditions using a film of a cured body having a thickness of about 50 µm prepared by being sandwiched between sheets of a PET resin with a reflectometric spectroscopy analyzer (V-650 made by JASCO Corporation).
Cell length: 10 mm
Measurement mode: T (Transmittance)
Measurement range: 450 to 200 nm
Data reading interval: 1 nm
UV/vis Band width: 2.0 nm
Response: medium
Scanning speed: 40 nm/min
Light source switching: 340 nm
Light source: D2/WI
Filter switching: Step
Correction: Base line

The amount of the UV absorber, which is the component (D), used may preferably be 0.01 to 5 parts by mass, and more preferably 0.5 to 2.5 parts by mass, based on 100 parts by mass of the total amount of the component (A) and (B). When the amount is 0.01 parts by mass or more, sufficient UV laser release rate is obtained, whereas when the amount is 5 parts by mass or less, an effect of less impairing the low outgas properties and heat resistance may be achieved.

The weight average molecular weight in the present description is measured by gel permeation chromatography (GPC) in terms of standard polystyrene. More specifically, the weight average molecular weight is determined by preparing a calibration curve using tetrahydrofuran as a solvent and using a GPC system (SC-8010 manufactured by Tosoh Corporation) with a commercially available standard polystyrene under the following conditions.
Flow rate: 1.0 ml/min
Set temperature: 40°C
Configuration of columns: a total of 3 columns of 1 column of "TSK guard column MP (× L)" 6.0 mmID × 4.0cm made by Tosoh Corporation and 2 columns of "TSK-GEL MULTIPORE HXL-M" 7.8 mm ID × 30.0 cm (theoretical plate number: 16,000 plates; the total theoretical plate number: 32,000 plates)
Amount of sample injected: 100 µl (concentration of sample solution 1 mg/ml)
Pressure of feeding liquid: 39 kg/cm²
Detector: RI detector (Differential index detector)

An embodiment of the present invention can also provide a cured body of the composition described above. The curing may be carried out using a light source to be described later. The cured body, when prepared in the form of a cured film having a thickness of 50 µm, it is preferable that one or more of the following conditions be satisfied, and it is more preferable that all be satisfied. The following conditions may be satisfied by using, for example an UV absorber.
· in the light transmittance of the cured film, a light transmittance in a wavelength region of 395 nm or more among the wavelengths of a light source used for curing is 70% or more;
· in the light transmittance of the cured film, a light transmittance in a wavelength region of 385 nm or more and less than 395 nm among the wavelengths of a light source used for curing is 20% or more; and
· in the light transmittance of the cured film, a light transmittance at a wavelength (355 nm) of UV laser used for UV laser release is 1% or less.

When these conditions are satisfied, the compatibility of sufficiently high curing rate and UV laser release rate for practical use is enabled. Further, in addition to the compatibility of sufficiently high curing rate and UV laser release rate, a mass reduction ratio under heating condition after curing may be reduced (or the amount of outgas under high temperature vacuum may be reduced). The temporary bonding agent having these properties may suitably be used particularly for the ion implantation in the back side step after thinning and for processes including high temperature vacuum process such as electrode formation by annealing and sputtering.

The present composition may be used as a resin composition for temporary bonding, an adhesive for temporary bonding, an adhesive sheet or an adhesive for temporary bonding for manufacturing an electronic device. In the present description, the composition for temporary bonding, the resin composition for temporary bonding and the adhesive for temporary bonding may collectively be called the temporary bonding agent.

When a substrate to be processed and optically transparent support substrate (or a support) are bonded using the present composition, it is preferable that the substrates be irradiated with visible light or ultraviolet light regions (wavelength or central wavelength of preferably 350 nm to 405 nm, more preferably 365 to 405 nm, and most preferably 385 nm to 405 nm) so that the amount of energy is 1 to 20,000 mJ/cm². An amount of energy of 1 mJ/cm² or more provides sufficient adhesiveness, and an amount of energy of 20,000 mJ/cm² or less provides excellent productivity, generates few decomposition products from photo radical polymerization initiator, and suppresses generation of outgas. The amount of energy is preferably 1 to 10,000 mJ/cm² from the viewpoints of productivity, adhesiveness, low outgas properties and easy release.

Although the substrate to be bonded using the composition is not particularly limited, it is preferable that at least one substrate be a transparent substrate which transmits light. Examples of transparent substrates may include inorganic substrates such as crystal, glass, quartz, calcium fluoride and magnesium fluoride, and organic substrates such as plastic. Of them, inorganic substrates are preferred because they are versatile and provide high effects. Of the inorganic substrates, one or more selected from glass and quartz are preferred.

The present composition may be photo-curable, and the cured body provided by such a composition has excellent heat resistance and releasability. In an embodiment the amount of outgas from the cured body of the composition of the present invention is small even when exposed to high temperature, and thus the cured body is suitable for bonding, encapsulating and coating various optical parts, optical devices and electronic parts. The composition of the present invention is suitable for applications in which wide-ranging durability such as solvent resistance, heat resistance and adhesiveness, is required, and in particular, suitable for processes for manufacturing semiconductors.

The cured body of the composition may be used in a process having a wide temperature range from room temperature to high temperature. The temperature of heating in a process may preferably be 350°C or less, more preferably 300°C or less, and most preferably 250°C or less. In a preferable embodiment, the temperature at which the mass reduction ratio of the cured body by heating reaches 2% by mass may be 250°C or more. The bonded body bonded using the composition has high shear adhesive strength and may withstand the step for thinning and the like, and may be easily released after the step for heating, such as forming an insulating film. When used at high temperature, the cured body of the composition may be used in a process at a high temperature of, for example, preferably 200°C or more, and more preferably 250°C or more.

In an embodiment, a bonded body to which a substrate is bonded using the present composition as an adhesive is also provided. The bonded body may be released by applying an external force. For example, it may be released by inserting a blade, sheet or wire into the bonded part. Alternatively, the substrate may be also released by irradiating the entire surface by scanning with UV laser or IR laser from the side of the optically transparent support of the bonded body.

### Method for producing thin wafer

An embodiment may also provide a method for producing a thin wafer. The production method comprises using the composition for temporary bonding or the adhesive for temporary bonding (hereinafter may be referred to as an adhesive or a temporary bonding agent) described above as an adhesive layer between a wafer with a semiconductor circuit and the like and a support. The method for producing the thin wafer comprises the following steps (a) to (e).

### Step (a)

The step (a) is a step in which, when bonding a circuit-bearing surface of a wafer having the circuit-bearing surface on the front and a circuit-free surface on the back to a support with an adhesive, the adhesive is applied to the support or the wafer with the circuit by spin coating to bond another support or wafer with circuit in vacuum.

The wafer having a circuit-bearing surface and a circuit-free surface has the circuit-bearing surface on one side and the circuit-free surface on the other side. Generally the present invention can be applied to semiconductor wafers. Examples of semiconductor wafers include not only silicon wafer but also gallium nitride wafer, lithium tantalate wafer, lithium niobate wafer, silicon carbide wafer, germanium wafer, gallium-arsenide wafer, gallium-phosphorus wafer and gallium-arsenide-aluminum wafer. The thickness of the wafer is not particularly limited, and is preferably 600 to 800 µm, and more preferably 625 to 775 µm. A transparent substrate which transmits light may be used as a support.

### Step (b)

The step (b) is for photo-curing the adhesive. It is preferable that after forming the processed wafer (laminated substrate), the wafer be irradiated with light in a region of visible light or ultraviolet light (wavelength or central wavelength is preferably 350 to 405 nm, more preferably 365 to 405 nm, and most preferably 385 to 405 nm) with the amount of energy of 1 to 20,000 mJ/ cm². An amount of energy of 1 mJ/ cm² or more provides sufficient adhesiveness, and an amount of energy of 20,000 mJ/ cm² or less provides excellent productivity, generates few decomposition products from photo radical polymerization initiator, and suppresses generation of outgas. The amount of energy is more preferably 1,000 to 10,000 cm² from the viewpoints of productivity, adhesiveness, low outgas properties and easy release.

The composition may be cured by using black light, UV-LED and visible light-LED as a light source and, for example, the following light sources may be used. For the black light, light including a component having a wavelength of 385 nm or more is preferably used regardless of the central wavelength thereof. When a wavelength range is described in the present description, it should be decided whether or not the range is included in the range based on whether or not the central wavelength is included in the range.
- Black light (central wavelength 365 nm, intensity 10 mW/cm², TUV-8271 made by TOYO ADTEC)
- UV-LED (wavelength 385±5 nm, intensity 350 mW/cm² (condition: work distance from mirror unit edge 20 mm), H-4MLH200-V2-1S19 + specially designed mirror unit made by HOYA CORPORATION)
- UV-LED (wavelength 395±5 nm, intensity 375 mW/cm² (condition: work distance from mirror unit edge 20 mm), H-4MLH200-V3-1S19 + specially designed mirror unit made by HOYA CORPORATION)
- UV-LED (wavelength 405±5 nm, intensity 400 mW/cm² (condition: work distance from mirror unit edge 20 mm), H-4MLH200-V4-1S19 + specially designed mirror unit made by HOYA CORPORATION)
- UV-LED (central wavelength 405 nm, intensity 10 mW/cm², HLDL-120V0-NWPSC made by CCS Inc.)
- Visible-LED (wavelength 451±5 nm, intensity 550 mW/cm² (condition: work distance from mirror unit edge 10 mm), HLDL-155VL450-PSC made by CCS Inc.)
- Visible-LED (wavelength 492±5 nm, intensity 400 mW/cm² (condition: work distance from mirror unit edge 10 mm), HLDL-155BG-PSC made by CCS Inc.)

In a preferable embodiment, UV-LED or visible-LED with a low integrated light intensity (only short irradiation time is required) may be a light source rather than black light with a high integrated light intensity generally due to a broad irradiation wavelength, likely extending the irradiation time. More specifically, the use of a LED light source having a narrow irradiation wavelength band enables the temporary bonding in a short time, thereby consequently providing an effect for saving time required for the manufacturing step.

### Step (c)

The step (c) is for grinding and/or polishing the circuit-free surface of the wafer bonded to the support, in other words, the step for grinding the back side of the processed wafer obtained by lamination in the step (a) to reduce the thickness of the wafer. The thinned wafer has a thickness of preferably 10 to 300 µm, and more preferably 30 to 100 µm. The method of grinding/polishing the back side of the wafer is not particularly limited and a known grinding/polishing method may be used. It is preferable that the wafer be ground while pouring water to the wafer and the grindstone (grindstone with a diamond blade and the like) to cool them.

### Step (d)

The step (d) is for processing the processed wafer whose circuit-free surface has been ground/polished; in other words, processing the circuit-free surface of the processed wafer which has been thinned by grinding/polishing the back side. The step includes various processes used at the wafer level, such as formation of electrodes, formation of metal wiring and formation of protective film. More specifically, it includes conventionally known processes such as metal sputtering for forming an electrode and the like, wet etching for etching the metal-sputtering layer, formation of patterns by application of resist for preparing mask for forming metal wiring, exposure and development, removal of resist, dry etching, formation of metal plating, silicon etching for forming TSV and formation of oxide film on the surface of silicon.

### Step (e)

The step (e) is a release step. In the step, the wafer processed in the step (d) is released from the processed wafer. For example, the step is for releasing the wafer from the processed wafer before dicing after doing various processing on the thinned wafer. At that stage, dicing tape may be attached in prior to the release to the side which has been thinned and processed. The release step is usually carried out in a condition of a relatively low temperature of room temperature to about 60°C. For the release step, any of a known UV laser release step, IR laser release step or mechanical release step may be employed.

The UV laser release step is a step for, for example, irradiating the entire surface of a processed wafer with UV laser so that the wafer is scanned with the laser linearly and reciprocally from the end of an optically transparent support in the direction of a tangent to decompose the adhesive layer with the energy of the laser to release the wafer. Such a release step is disclosed in, for example, Japanese Translation of PCT International Application Publication No. 2019-501790, and Japanese Translation of PCT International Application Publication No. 2016-500918.

The IR laser release step is a step for, for example, irradiating the entire surface of a processed wafer with IR laser so that the wafer is scanned with the laser linearly and reciprocally from the end of an optically transparent support in the direction of a tangent to heat and decompose the adhesive layer with the energy of the laser to release the wafer. Such a release step is disclosed in, for example, Japanese Patent 4565804. To perform the IR laser release step, a light heat converting layer (e.g., "LTHC; Light-To-Heat-Conversion release coating" manufactured by 3M) which absorbs IR laser light and converts it to energy may be provided between a layer of temporary bonding agent and a glass support. When LTHC made by 3M is used, LTHC is, for example, spin-coated and cured on the glass support. Then, the layer of temporary bonding agent, which is spin-coated on wafer, is laminated on the glass support on which the LTHC layer has been formed, and they may be UV cured. The method for carrying out the IR laser release step using LTHC made by 3M is disclosed, for example, in Japanese Patent No. 4565804 described above.

The mechanical release step includes, for example, horizontally fixing the processed wafer with the wafer facing downward so as to insert a blade into the end of the interface of the processed wafer to make an opening between the wafer and the support and after inserting the blade, applying upward stress to the support and/or the blade on the upper side to extend the opening to release the wafer from the support. Such a release step is disclosed in, for example, Japanese Patent No. 6377956 and Japanese Patent Laid-Open No. 2016-106404.

Any of the above release methods may be used for releasing the composition. It is preferable that in these cases, one end of the wafer of the processed wafer or the support be horizontally fixed and then a blade be inserted thereinto, or the periphery of the adhesive layer be swollen using a solvent (e.g., aliphatic or an aromatic hydrocarbon solvents such as pentane, hexane, heptane, octane, nonane, decane, benzene, toluene, xylene and mesitylene) to cause release, and the other end be lifted at a certain angle in the horizontal direction. Although these methods are usually performed at room temperature, heating at an upper limit of about 90°C is also preferred. When laser is used, YAG laser or YVO₄ laser is preferably used.

When the above step (e) for releasing the processed wafer from a support is a mechanical release step, it is preferable that the step further may include the steps of:
(f) adhering dicing tape on the wafer surface of a processed wafer,
(g) vacuum sucking the side of the dicing tape to the suction surface, and
(h) releasing the support from the processed wafer at a temperature of the suction surface ranging from 10 to 100°C. This facilitates release of the support from the processed wafer and makes it easier to perform the subsequent dicing step.

When the release is performed with UV laser or IR laser, the production method may preferably further comprise the steps of:
(i) setting and fixing a processed wafer at a horizontal position with an optically transparent support facing upward preferably via dicing tape, and
(j) irradiating the entire surface of the processed wafer by scanning with laser from the side of the support.

This facilitates release of the support from the processed wafer and makes it easier to perform the subsequent dicing step.

The step (e) for releasing the processed wafer from the support with UV laser or IR laser may perform a subsequent step of:
(k) removing the temporary bonding agent remaining on the surface of the wafer.

The method for removing the temporary bonding agent includes a method in which the thinned side is vacuum sucked on the suction surface, while an adhesive tape such as dicing tape is attached to the entire surface of the other side on which the temporary bonding agent is remaining to peel the temporary bonding agent together with the tape, and a method in which the wafer is immersed in a solvent (e.g., aliphatic or aromatic hydrocarbon solvents such as pentane, hexane, heptane, octane, nonane, decane, benzene, toluene, xylene and mesitylene) and the adhesive layer is swollen to cause release. Of these methods, the tape release method is preferable from the viewpoints of fewer numbers of steps and short time required.

The wafer after the temporary bonding agent is removed may be sent to the subsequent step without washing the surface. It is preferable that when the surface is to be washed, the method may comprise:
a step (I) for washing the wafer from which the support and the temporary bonding agent have been removed using a solvent (e.g., aliphatic or aromatic hydrocarbon solvents such as pentane, hexane, heptane, octane, nonane, decane, benzene, toluene, xylene and mesitylene) be further performed with the circuit-bearing surface facing upward.

A part of the adhesive (temporary bonding agent) may remain on the circuit-bearing surface of the wafer from which the temporary bonding agent has been removed in the step (k). While it is preferable that the support released be washed and reused, residue of adhesive may have been adhered on the surface of the support. Examples of methods for removing these residues of adhesive include a method in which the wafer and the support are immersed in a solvent (e.g., aliphatic or aromatic hydrocarbon solvents such as pentane, hexane, heptane, octane, nonane, decane, benzene, toluene, xylene and mesitylene), and the residual adhesive is swollen to cause release.

In an embodiment, when obtaining a cured body by curing the composition, various techniques as follows may be employed.

In the first technique, a layer of the composition for temporary bonding comprising the components described above is cured, thereby enabling to obtain a single layer cured body.

The second technique is a technique in which a first layer comprising a composition for temporary bonding having at least a component (A) to a component (C), and does not have an UV absorber, which is a component (D), and a second layer comprising a composition for temporary bonding having at least the component (A) to the component (D) are respectively prepared and cured, thereby obtaining a cured body having an integrated single layer or multilayer (multiple layers). This cured body is preferable in the aspects that a component concentration distribution in the thickness direction varies or a component concentration distribution varies in the upper side and the lower side in the thickness direction of the cured body. The variation in a component concentration distribution may be confirmed by quantitatively determining UV transmittances of the both sides of the cured body by the reflectometric spectroscopy described above. This technique may provide the effect for realizing the optimum curing by combining layers with different light transmission properties. In the curing described above, black light and UV-LED may be used as a light source (the same applies to the following techniques). Examples of black light include TUV-8271 (central wavelength 365 nm, intensity 10 mW/cm²) made by TOYO ADTEC. Examples of UV-LED include H-4MLH200-V2-1S19 + specially designed mirror unit (wavelength 385±5 nm, intensity 350 mW/cm², condition: scan pitch from mirror unit edge 20 mm) made by HOYA CORPORATION, H-4MLH200-V3-1S19 + specially designed mirror unit (wavelength 395±5nm, intensity 375 mW/cm², condition: work distance from mirror unit edge 20 mm) made by HOYA CORPORATION, and H-4MLH200-V4-1S19 + specially designed mirror unit (wavelength 405±5 nm, intensity 400 mW/cm², condition: work distance condition: work distance 20 mm) made by HOYA CORPORATION.

As the third technique, a multilayer cured body may be obtained by putting a layer of a commercial LTHC agent (light heat converting agent) on a layer comprising a composition for temporary bonding having at least a component (A) to a component (C) and curing. This may provide an effect for easily obtaining a cured body.

The cured body obtained by the techniques described above may be provided as a structure in combination with an adherend.

The method for producing the structure described above include various examples. For example, the first production method may comprise a step for applying a first composition for temporary bonding having at least a component (A) to a component (C), and not having a component (D) on a wafer to cure partially, a step for applying a second composition for temporary bonding comprising at least the component (A) to the component (D) on the partially cured composition for temporary bonding, and a step for further putting a transparent substrate on the applied second composition for temporary bonding to photo-cure.

The second method for producing the structure may comprise a step for applying a first composition for temporary bonding having at least a component (A) to a component (C), and not having a component (D) on a wafer to cure partially as needed, a step for applying a second composition for temporary bonding comprising at least the component (A) to the component (D) on a transparent substrate to cure partially as needed, and a step for firmly attaching faces of the wafer and the transparent substrate respectively on which the composition for temporary bonding has been applied and then bonding by photo-curing.

Apart from the composition for temporary bonding described above, the same composition as used for the composition for temporary bonding of the present invention may also be used as a raw material of a light heat converting (LTHC) layer which absorbs IR laser light and converts it to energy disclosed in Japanese Patent No. 4565804. Using the present composition as a component for the light heat converting (LTHC) layer may improve heat resistance thereof.

An embodiment provides a method for producing a semiconductor wafer comprising a step for applying a composition for temporary bonding to a semiconductor wafer substrate and/or a support member to bond the semiconductor wafer substrate and the support member, a step for curing the adhesive for temporary bonding by irradiating with light having a wavelength of 350 to 700 nm (preferably 365 to 500 nm, more preferably 385 to 450 nm) to obtain a bonded body, and a step for irradiating the bonded body with leaser light having a wavelength of less than 385 nm (preferably laser light having a wavelength of 200 nm or more and a wavelength of less than 385 nm) to release the semiconductor wafer substrate. The present production methods have both steps for curing and releasing performed at room temperature, do not need to heat or cool a member, generally do not need to use a solvent and the like, and are simple with short takt time (cycle time), hence beneficial.

Further, the cured adhesive for temporary bonding may constitutes a single layer in the bonded body. It may simplify steps and reduce takt time.

In a preferable embodiment, the composition comprises the photo radical polymerization initiator of the component (C) and the UV absorber of the component (D) described above, thereby enabling a fast curing rate and a fast release rate to be compatible even the adhesive for temporary bonding is a single layer. Further, it is possible to notably reduce an uncured UV curable monomer component remaining on the cured body when UV-curing the adhesive for temporary bonding, thereby enabling heat resistance of the cured body to be improved and a volatile matter under an atmosphere of nitrogen to be reduced. More specifically, for example, it is possible to increase the temperature at which the mass reduction by heating reaches 2% when measuring Tg/DTA of the cured body. The adhesive for temporary bonding having a high heat resistance of the cured body and a reduced volatile matter under an atmosphere of nitrogen is extremely useful for the recent semiconductor manufacturing process. The present cured body may preferably have the temperature at which the mass reduction reaches 2% of 300°C or more, preferably 320°C or more, and more preferably 326°C or more, under an atmosphere of nitrogen.

In an embodiment, a method for producing a substrate for an electronic device may be provided. Such a production method may comprise the steps of mixing a monofunctional (meth)acrylate, a polyfunctional (meth)acrylate, and a photo radical polymerization initiator to prepare a composition having a viscosity at 23°C ranging from 500 to 10,000 mPa·s, applying the prepared composition onto a silicon wafer by spin coating method so that the surface of the applied composition has flatness with a difference in height only of 40 µm or less, and bonding a support to the silicon wafer so as to sandwich the applied composition therebetween. In the present description, the measurement of the flatness of the composition surface is carried out after the composition is applied using a spin coater and cured under the conditions described in an example to be described later.

### EXAMPLES

Hereinafter the present invention will be described in more detail with reference to Examples and Comparative Examples, but the present invention is not limited thereto.

Experiments were carried out at 23°C and a humidity of 50% unless otherwise specified. The curable resin compositions (hereinafter may be referred to as a liquid resin composition) having the composition (unit is the part by mass) shown in Tables below were prepared and evaluated. The following compounds were selected as the components.

**[Table 1]**

| Example/Comparative Example | Comparative Example | Comparative Example | Comparative Example | Comparative Example | Comparative Example |
|---|---|---|---|---|---|
| | 1 | 2 | 3 | 4 | 5 |
| HX620 | 50 | 67.5 | 53.7 | - | - |
| HX220 | - | - | - | - | - |
| A-BPEF-2 | 25 | 30 | 33.9 | - | 10 |
| A-BPE-2 | 25 | 2.5 | 2.8 | - | - |
| RA-341 | - | - | - | - | 15 |
| RC100C | - | - | - | - | - |
| DCP | - | - | - | 30 | - |
| A-DCP | - | - | - | - | 35 |
| LA | - | - | - | - | - |
| NOAA | - | - | - | - | - |
| INAA | - | - | - | - | - |
| ISTA | - | - | - | 65 | |
| ACMO | - | - | 9.6 | - | 40 |
| Tetrax 6T | - | - | - | 5 | - |
| Irgacure819 | 0.5 | 0.5 | 0.5 | 0.5 | 0.5 |
| Tinuvin460 | 2 | - | - | - | - |
| Tinuvin479 | - | 2 | - | 2 | - |
| RUVA-93 | - | - | 3 | - | 3 |
| Surface tension of composition mN/m @ 23 °C | 38 | 39 | 40 | 27 | 34 |
| Temperature at which mass reduction reaches 2% (°C) | 351 | 340 | 301 | 315 | 300 |
| Vacuum heat resistance | Good to Excellent | Excellent | Excellent | Excellent | Excellent |
| Laser releasability | Excellent | Excellent | Excellent | Failure | Excellent |
| Viscosity of composition (mPa·s) @ 23 °C | 2520 | 1870 | 1340 | 1360 | 930 |
| Edge bead height (µm) | 44 | 45 | 60 | 25 | 50 |

**[Table 2]**

| Example/ Comparative Example | Example | Example | Example | Example | Example | Example | Example | Example | Example | Example |
|---|---|---|---|---|---|---|---|---|---|---|
| | 1 | 2 | 3 | 4 | 5 | 6 | 7 | 8 | 9 | 10 |
| HX620 | 57.5 | 47.5 | - | - | 57.5 | - | 55 | - | - | - |
| HX220 | - | - | - | - | - | 52.5 | | - | - | - |
| A-BPEF-2 | 30 | 30 | - | 10 | 30 | 25 | 30 | 10 | 10 | 10 |
| A-BPE-2 | 2.5 | 2.5 | - | - | 2.5 | - | 5 | - | - | - |
| RA-341 | - | - | - | 15 | - | 2.5 | - | 15 | 15 | 15 |
| RC100C | - | - | 40 | - | - | - | - | - | - | - |
| DCP | - | - | - | - | - | - | - | - | - | - |
| A-DCP | - | - | 30 | 35 | - | - | - | 35 | 35 | 35 |
| LA | - | - | - | - | - | - | - | 40 | - | - |
| NOAA | - | - | - | - | - | - | - | - | 40 | - |
| INAA | - | - | - | - | - | - | - | - | - | 40 |
| ISTA | 10 | 20 | 30 | 40 | 20 | 20 | 10 | - | - | - |
| ACMO | - | - | - | - | - | - | - | - | - | - |
| Tetrax 6T | - | - | - | - | - | - | - | - | - | - |
| Irgacure819 | 0.5 | 0.5 | 0.5 | 0.5 | 0.5 | 0.5 | 0.5 | 0.5 | 0.5 | 0.5 |
| Tinuvin460 | - | - | - | - | - | - | - | - | - | - |
| Tinuvin479 | - | - | - | - | - | - | - | - | - | - |
| RUVA-93 | 3 | 3 | 3 | 3 | 3 | 3 | 3 | 3 | 3 | 3 |
| Surface tension of composition mN/m @ 23°C | 30 | 30 | 29 | 29 | 30 | 29 | 31 | 31 | 31 | 31 |
| Temperature at which mass reduction reaches 2% (°C) | 351 | 354 | 343 | 350 | 349 | 352 | 351 | 349 | 340 | 332 |
| Vacuum heat resistance | Excellent | Excellent | Excellent | Excellent | Excellent | Excellent | Excellent | Excellent | Excellent | Excellent |
| Laser releasability | Excellent | Excellent | Good | Excellent | Excellent | Excellent | Excellent | Excellent | Excellent | Excellent |
| Viscosity of composition (mPa·s) @ 23°C | 1340 | 1020 | 1390 | 2250 | 1490 | 764 | 1678 | 550 | 503 | 532 |
| Edge bead height (µm) | 38 | 32 | 35 | 30 | 33 | 30 | 35 | 32 | 32 | 32 |

### Composition

The following compounds were used as the component (A). The value of the surface tension was measured by the ds/de method at 23°C using "OCA20" made by EKO INSTRUMENTS CO., LTD. The surface tension of the composition as a whole was similarly measured.
LA: Lauryl acrylate ("LA" made by Osaka Organic Chemical Industry Ltd., surface tension 29.3 mN/m)
NOAA: n-Octyl acrylate ("NOAA" made by OSAKA ORGANIC CHEMICAL INDUSTRY LTD., surface tension 27.5 mN/m)
INAA: Isononyl acrylate ("INAA" made by OSAKA ORGANIC CHEMICAL INDUSTRY LTD., surface tension 27.5 mN/m)
ISTA: Isostearyl acrylate ("ISTA" made by OSAKA ORGANIC CHEMICAL INDUSTRY LTD., surface tension 26.3 mN/m)
ACMO: Acryloylmorpholine ("ACMO" made by KJ Chemicals Corporation, surface tension 44.6 mN/m)

The following compounds were used as the component (B). The value of the viscosity or being in the solid state are at 23°C.
HX-620: Caprolactone-modified hydroxy pivalic acid neopentyl glycol diacrylate ("KAYARAD HX-620" made by Nippon Kayaku Co., Ltd., m+n≈4, (average) molecular weight 768, viscosity 290 mPa·s)
HX-220: Caprolactone-modified hydroxy pivalic acid neopentyl glycol diacrylate ("KAYARAD HX-220" made by Nippon Kayaku Co., Ltd., m+n≈2, (average) molecular weight 541, viscosity 120 mPa·s)
A-BPEF-2: 9,9-Bis[4-(2-hydroxyethoxy)phenyl]fluorene diacrylate ("NK ester A-BPEF-2" made by Shin-Nakamura Chemical Co., Ltd., molecular weight 546, highly viscous beyond the measurement limit, decided to have more than 1,000 mPa·s)
RA-341: Polyfunctional methacrylate polymer ("ART CURE RA-341" made by Negami Chemical Industrial Co., Ltd., weight average molecular weight of trunk polymer about 70,000, highly viscous beyond the measurement limit, decided to have more than 1,000 mPa·s)
A-BPE-2: Ethoxylated bisphenol A diacrylate ("NK ester A-BPE-2" made by Shin-Nakamura Chemical Co., Ltd., in the structural formula below, R=-CH₂CH₂O-, m=n=1, molecular weight 422, solid at 23°C) 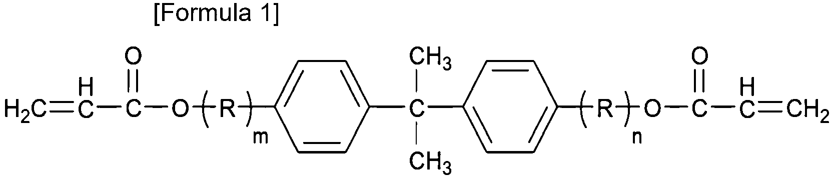
RC100C: Acrylate polymer having acryloyl groups on both terminals ("KANEKA XMAP RC100C" made by KANEKA Corporation, having the following structural formula, (weight average) molecular weight 24,000, highly viscous beyond the measurement limit, decided to have more than 1,000 mPa·s)

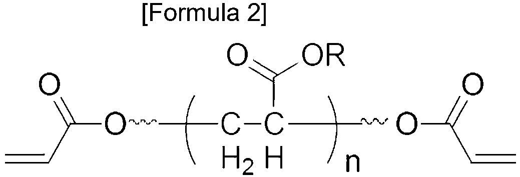

The following compounds were used as other components for comparative examples.
Tetrax 6T: Polyisobutylene ("Tetrax Grade 6T" made by ENEOS Materials Corporation, viscosity average molecular weight 60,000)
A-DCP: Tricyclodecanedimethanol diacrylate ("NK ester A-DCP" made by Shin-Nakamura Chemical Co., Ltd., molecular weight 304, viscosity 160 mPa·s)
DCP: Tricyclodecanedimethanol dimethacrylate ("NK ester DCP" made by Shin-Nakamura Chemical Co., Ltd., molecular weight 332, viscosity 130 mPa·s)

The following compound was used as the component (C). Bis(2,4,6-trimethylbenzoyl)phenylphosphine oxide ("Irgacure 819" made by BASF)

The following compound was used as the component (D).
2,4-Bis(2-hydroxy-4-butyloxyphenyl)-6-(2,4-bis-butyloxyphenyl)-1,3,5-triazine ("Tinuvin 460" made by BASF)
Hydroxyphenyl triazine UV absorber ("Tinuvin 479" made by BASF)
2-(2'-Hydroxy-5'-methacryloyloxyethylphenyl)-2H-benzotriazole ("RUVA-93" made by Otsuka Chemical Co., Ltd.)

### Preparation of liquid sample

Materials were mixed while heating at 80°C to prepare a homogeneous mixture. The viscosities of the components and compositions as a whole were measured as values at the temperature condition of 23°C and a shear rate at 1 s⁻¹ using a rotary rheometer MCR302 made by Anton-Paar and Cone plate CP50-2. In the measurement of the viscosities of the component (B) and the polyfunctional (meth)acrylates as comparative examples thereof, when the measurement was impossible using the rotatory rheometer under the above measurement conditions due to too high viscosity, the viscosity was decided to have apparently more than 1,000 mPa·s (highly viscous of presumably more than 100,000 mPa·s).

### Measurement of temperature at which mass is reduced by 2%

The liquid resin composition homogenized by the above mixing was sandwiched between PET films, pressed out to make the thickness down to 70 µm, and cured in a condition of an integrated light intensity of 5,000 mJ/cm² to prepare a cured body sample. UV-LED (central wavelength 405 nm, intensity 100 mW/cm², wafer UV irradiation equipment MUVBA-0.4 × 0.6 × 0.2 - 0010 made by AITEC SYSTEM Co., Ltd.) was used for curing.

The cured body sample weighed to 10 mg was increased in temperature from room temperature to 600°C in a temperature increase rate of 10°C/min, using a simultaneous thermogravimetry/differential thermal analyzer "STA-2500" made by NETZSCH Japan K.K., under a stream of nitrogen at a carrier gas flow rate of 70 ml/min, and then the cured body was weighed. Using the obtained weight, the mass reduction ratio by heating (temperature at which mass is reduced by 2%) under an atmosphere of nitrogen was calculated.

### Evaluation on vacuum heat resistance

A 4-inch silicon wafer (diameter 10 cm × thickness 525 µmt) was laminated with a 4-inch glass wafer (diameter 10 cm × thickness 0.7 mm) using the liquid resin composition prepared to prepare a 4-inch sample. When laminating, the thickness of the resin composition was adjusted by using a mixture of the temporary bonding agent to which 0.1% by mass of glass beads made by UNITIKA LTD. (product name SPL-70, average particle size 70 µm) was added and mixed. After laminating, the composition was cured in a condition of an LED integrated light intensity of 5,000 mJ/cm² (central wavelength 405 nm, intensity 100 mW/cm²) to prepare a bonded sample. UV-LED (central wavelength 405 nm, intensity 100 mW/cm², wafer UV irradiation equipment MUVBA-0.4 × 0.6 × 0.2 - 0010 made by AITEC SYSTEM Co., Ltd.) was used for curing. The obtained bonded sample was evaluated for vacuum heat resistance. Further, the obtained bonded sample was evaluated for the vacuum heat resistance to be described later.

Each bonded sample was put in a vacuum hot plate chamber, heated for 1 hour under a condition of 300°C and 20 Pa, and then the end of the circumferential side of the silicon wafer was visually observed to evaluate based on the criteria below.
Excellent: Not released at the end at all.
Good: Length of the released part at the end was less than 5 mm from edge.
Pass: Length of the released part at the end was 5 mm or more and less than 10 mm from edge.
Failure: Length of the released part at the end was 10 mm or more from edge.

### Evaluation of laser releasability

The bonded sample of the 4-inch sample prepared as described above was irradiated with UV laser so that the sample was scanned throughout the entire surface from the side of glass support to an area of 210 mm-square where the sample was fixed in center thereof. The UV laser irradiation conditions are shown below. For the UV laser, "MD-U1020C" made by KEYENCE CORPORATION was used. The irradiation was carried out under the conditions of output 2.5 W, frequency 40 kHz, beam diameter 72 µm, scan pitch 150 µm, and scan speed 6 m/sec. The releasability after irradiation was evaluated based on the definitions below. A sample in the state where the glass support is easily releasable by hand from the temporary bonding agent without adhesiveness is defined as "Excellent". A sample in the state where the glass support is releasable by hand from the temporary bonding agent with adhesiveness remained is defined as "Good". A sample in the state where the glass support is not releasable by hand from the temporary bonding agent is defined as "Failure".

### Evaluation of edge bead height

On an 8-inch Si wafer, 6.5 to 7.5 g of the prepared resin composition was applied using a spin coater (MS-A300 made by MIKASA CO., LTD.), rotated at a low-revolution speed (50 rpm × 15 sec), and then the liquid was uniformly spread all over at a high-revolution speed under the conditions below. The upper surface was moved into a glass chamber, whose inside was purged with a nitrogen atmosphere, and cured in a condition of an LED integrated light intensity of 8,100 mJ/cm² (central wavelength 405 nm, intensity 45 mW/cm²). The thickest part of the edge part and a part 2 cm or more inward from the edge part were measured, and the difference therebetween was defined as the height of edge bead.
High-revolution speed conditions
Revolution time: 15 seconds
Revolution speed: N rpm (number of revolutions under the conditions in which the thickness is 74 to 76 µm when the application time is 15 seconds by the following equation using the value of viscosity)
Applied amount: 6.5 to 7.5 g $h = h 0 / {\left\{1+t\times \left(4{ω}^{2}{h 0}^{2}/3ν\right)\right\}}^{1 / 2}$
h: film thickness [mm], h0: initial film thickness [mm], ω: revolution speed [rad/sec],
t: time [sec], v: kinematic viscosity [mm²/sec]
Revolution speed $ω = πN / 30$
ω: revolution speed [rad/sec], number of revolutions [rpm]
Kinematic viscosity $ν = μ / ρ$
v: kinematic viscosity [m²/sec], µ: viscosity [Pa·s], ρ: density [kg/m³]
Initial film thickness $h 0 = \left\{w/\left(s\times ρ\right)\right\} \times 10$
h0: initial film thickness [mm], w: applied amount [g], s: wafer area [cm²], ρ: density [g/cm³]

The above results revealed that the compositions of the examples of the present invention all had edge bead heights of 40 µm or less with good laser releasability and heat resistance. On the other hand, Comparative Examples 1 and 2, which do not contain the component (A), had high edge beads, thereby failing to prevent air bubbles from mixing in. Comparative Examples 3 and 5, which do not satisfy the conditions of the surface tension of the component (A), also had high edge beads. Comparative Example 4, which do not contain the component (B), had poor laser releasability thereby being unsuitable for practical use.

## Claims

1. A cured body of a composition for temporary bonding, the composition comprising the following (A) to (C), and having a viscosity ranging from 500 to 10,000 mPa·s at atmospheric pressure at 23°C and a shear rate at 1 s⁻¹ as measured by a rotatory rheometer:
(A) a monofunctional (meth)acrylate having a surface tension ranging from 20 to 30 mN/m as measured by ds/de method of pendant drop method at 23°C;
(B) a polyfunctional (meth)acrylate, which has a viscosity of 1,000 mPa·s or more at atmospheric pressure at 23°C and a shear rate at 1 s⁻¹ as measured by a rotatory rheometer, is solid at 23°C, or has a molecular weight of 500 or more and a viscosity of 100 mPa·s or more and less than 1,000 mPa·s at atmospheric pressure at 23°C and a shear rate at 1 s⁻¹ as measured by a rotatory rheometer; and
(C) a photo radical polymerization initiator,
wherein the cured body has a temperature at which mass is reduced by 2% of 300°C or more under an atmosphere of nitrogen, as measured by a method disclosed in the present description.

2. The cured body of the composition for temporary bonding according to claim 1, wherein an amount of the component (A) ranges from 5 to 65% in a mass ratio of the component (A) to the component (B).

3. The cured body of the composition for temporary bonding according to claim 1 or 2, wherein the component (A) is an aliphatic monofunctional (meth)acrylate.

4. The cured body of the composition for temporary bonding according to claim 3, wherein the number of carbon atoms of the aliphatic group of the component (A) is 6 or more and 30 or less.

5. The cured body of the composition for temporary bonding according to any one of claims 1 to 4, wherein the component (B) contains an oligomer or a polymer.

6. The cured body of the composition for temporary bonding according to any one of claims 1 to 5, further comprising:
(D) an UV absorber.

7. A method for producing a substrate for an electronic device, the method comprising the steps of:
mixing a monofunctional (meth)acrylate, a polyfunctional (meth)acrylate, and a photo radical polymerization initiator to prepare a composition according to one of the preceding claims having a viscosity at 23°C ranging from 500 to 10,000 mPa·s and a shear rate at 1 s⁻¹ as measured by a rotatory rheometer;
applying the prepared composition onto a silicon wafer by spin coating method so that the surface of the applied composition has flatness with a difference in height only of 40 µm or less; and
bonding a support to the silicon wafer so as to sandwich the applied composition therebetween, and
photo-curing the composition to obtain a cured body, wherein the cured body has a temperature at which mass is reduced by 2% of 300°C or more under an atmosphere of nitrogen, as measured by the method disclosed in the present description.
